# EUROPÄISCHE PATENTSCHRIFT

(11) **EP 2 897 011 B1**
(45) Veröffentlichungstag und Bekanntmachung des Hinweises auf die Patenterteilung: **21.08.2019**
(21) Anmeldenummer: 14151926.4
(22) Anmeldetag: 21.01.2014
(51) Int. Cl.: G05B 19/418

(54) **Verfahren und Simulationsanordnung zur Simulation einer automatisierten Industrieanlage**
Method and simulation assembly for the simulation of an automated industrial plant
Procédé et système de simulation pour la simulation d'une installation industrielle automatisée

(43) Veröffentlichungstag der Anmeldung: 22.07.2015
(73) Patentinhaber: Siemens Aktiengesellschaft, 80333 München (DE)
(72) Erfinder: Drumm, Oliver, 76344 Eggenstein-Leopoldshafen (DE); Lutz, Benjamin, 76327 Pfinztal (DE); Pfleger, Christoph, 76133 Karlsruhe (DE)

(56) Entgegenhaltungen:
- WO-A1-2011/023204
- DE-A1-102011 055 657
- GUILLERMO VIGUERAS ET AL: "Workload balancing in distributed crowd simulations: the partitioning method", THE JOURNAL OF SUPERCOMPUTING, Bd. 58, Nr. 2, 19. Dezember 2009 (2009-12-19), Seiten 261-269, XP055121688, ISSN: 0920-8542, DOI: 10.1007/s11227-009-0375-5
- WOOK HYUN KWON ET AL: "Real-time distributed software-in-the-loop simulation for distributed control systems", COMPUTER AIDED CONTROL SYSTEM DESIGN, 1999. PROCEEDINGS OF THE 1999 IE EE INTERNATIONAL SYMPOSIUM ON KOHALA COAST, HI, USA 22-27 AUG. 1999, PISCATAWAY, NJ, USA,IEEE, US, 22. August 1999 (1999-08-22), Seiten 115-119, XP010360421, ISBN: 978-0-7803-5500-2
- PAPAZOGLOU M P ET AL: "Service-oriented computing", COMMUNICATIONS OF THE ACM, ASSOCIATION FOR COMPUTING MACHINERY, INC, UNITED STATES, Bd. 46, Nr. 10, 1. Oktober 2003 (2003-10-01), Seiten 25-28, XP002497726, ISSN: 0001-0782, DOI: 10.1145/944217.944233

## Beschreibung

Die Erfindung betrifft ein Verfahren zur Simulation einer automatisierten Industrieanlage, wobei die Industrieanlage in ein Anlagenmodell abgebildet wird und das Anlagenmodell in mehrere Teilmodelle aufgeteilt wird, die Teilmodelle werden dabei mit einer Verhaltensbeschreibung modeliert, welche einen Berechnungsalgorithmus oder eine mathematische Gleichung aufweisen, jedes Teilmodell wird gemäß der Abbildung der Industrieanlage in das Anlagenmodell mit mindestens einem anderen Teilmodell verschaltet, wobei in Vorbereitung zu der Simulation das Anlagenmodell bzw. die Teilmodelle durch einen Übersetzungslauf in eine Form übersetzt werden, welche von einem Computersystem, auf welchen die Simulation ausgeführt werden wird, ausgeführt werden kann, dabei wird zusätzlich eine Ausführungsreihenfolge der Teilmodelle festgelegt.

Des Weiteren betrifft die Erfindung eine Simulationsanordnung zur Simulation einer automatisierten Industrieanlage, umfassend ein Computersystem mit einer Simulationssoftware, einer Bibliothek mit einer Mehrzahl von Teilmodellen, einem Komponenteneditor zur Erstellung eines Anlagenmodells für eine Industrieanlage, wobei die Industrieanlage mittels einer Verknüpfung der Teilmodelle auf das Anlagenmodell abbildbar ist, wobei die Teilmodelle einen Berechnungsalgorithmus oder eine mathematische Gleichung aufweisen, mit einem Übersetzungsmittel, welches ausgestaltet ist, das Anlagenmodell durch eine Übersetzung in eine Form zu bringen, welche von dem Computerprogramm, mit der Simulationssoftware für die Simulation, ausführbar ist, mit einem Disponentenmittel, welches ausgestaltet ist, gemäß der Verknüpfung der Teilmodelle eine Ausführungsreihenfolge für die Teilmodelle festzulegen.

Beispielsweise bei einem Operator Training System (OTS) oder bei Systemen zur virtuellen Inbetriebnahme (VIBM) werden im Umfeld der Prozessindustrie vorzugsweise echtzeitfähige Simulationsmodelle eingesetzt. Im Sinne der Erfindung bedeutet Echtzeit oder Echtzeitfähigkeit, dass eine simulierte Zeiteinheit (Zeitscheibe) in der Dauer einer Abtastzeit eines Automatisierungsgerätes entspricht. Demnach versteht man unter Echtzeitbetrieb den Betrieb eines Rechnersystems, bei dem Programme zur Verarbeitung anfallender Daten ständig betriebsbereit sind, und zwar derart, dass die Verarbeitungsergebnisse innerhalb einer vorgegebenen Zeitspanne verfügbar sind.

Aus dem Stand der Technik ist ein Simulationsverfahren und eine Simulationsanordnung aus dem Siemens-Benutzerhandbuch "SIMIT SCE", Ausgabestand Juli 2009, SIMIT-HB-SCE-2009-07, bekannt. Bei diesen bekannten Simulationsverfahren werden Anlagenmodelle für den Simulator erstellt, und beispielsweise über einen längeren Zeitraum ausgeführt. Bei einer Simulation der Anlagenmodelle über einen längeren Zeitraum kann es vorkommen, dass Laufzeitverletzungen auftreten, d.h. Laufzeiten der Modelle dauern länger, als ein vorgegebener Simulationszyklus, welcher wiederum einer realen Zeitdauer entspricht.

DE 10 2011 055657 A1 offenbart ein Verfahren zur Simulation einer automatisierten Industrieanlage, wobei die Industrieanlage in ein Anlagenmodell abgebildet wird und das Anlagenmodell in mehrere Teilmodelle aufgeteilt wird, die Teilmodelle werden dabei mit einer Verhaltensbeschreibung moduliert, welche einen Berechnungsalgorithmus oder eine mathematische Gleichung aufweisen, jedes Teilmodell wird gemäß der Abbildung der Industrieanlage in das Anlagenmodell mit mindestens einem anderen Teilmodell verschaltet, wobei in Vorbereitung zu der Simulation das Anlagenmodell bzw. die Teilmodelle durch einen Übersetzungslauf in eine Form übersetzt werden, welche von einem Computersystem, auf welchen die Simulation ausgeführt werden wird, ausgeführt werden kann, dabei wird zusätzlich eine Ausführungsreihenfolge der Teilmodelle festgelegt.

Aufgabe der vorliegenden Erfindung ist es, spätere Laufzeitverletzungen für ein zu simulierendes Anlagenmodell während der Simulation zu vermeiden.

Die Aufgabe wird für das Verfahren zur Simulation einer automatisierten Industrieanlage mit den Merkmalen des Oberbegriffes des unabhängigen Patentanspruches 1 dadurch gelöst, dass die Teilmodelle vor dem Übersetzungslauf jeweils um ein Laufzeitmodell erweitert werden, wobei die Laufzeitmodelle eine dem jeweiligen Teilmodell zugeordnete Berechnungszeit aufweisen, wobei anhand der Ausführungsreihenfolge und der um die Laufzeitmodelle erweiterten Teilmodelle eine Gesamtberechnungszeit des Anlagenmodells in der Granularität der Berechnungszeiten der Teilmodelle abgeleitet und grafische dargestellt wird, wodurch eine Erkennung und Lokalisierung von echtzeitkritischen Ablauffaden in dem Anlagenmodell möglich wird. Erfindungsgemäß wird eine Erweiterung von Simulationskomponenten, insbesondere von Teilmodellen, durch Laufzeitmodelle vorgesehen. In Abhängigkeit der Komplexität eines Teilmodells und der Leistung eines Rechners kann die Berechnungszeit für ein Teilmodell in einer simulierten Zeiteinheit schwanken und somit können auch Laufzeitverletzungen eintreten. Mithilfe der Erfindung ist vor dem Start einer Simulation sichergestellt, dass die Simulation in Echtzeit bzw. auf Basis der virtuellen Zeit ablauffähig ist und keine Laufzeitverletzungen auftreten.

In einer vorteilhaften Ausgestaltung des Verfahrens wird die Berechnungszeit der Teilmodelle in Abhängigkeit von zumindest einem Parameter, welcher die Berechnungszeit während der Ausführung der Teilmodelle situationsbedingt beeinflusst, in den Laufzeitmodellen hinterlegt, wobei als der zumindest eine Parameter eine Rechnerkonfiguration des Computersystems gewählt wird. Mit einer Rechnerkonfiguration bezeichnet man eine bestimmte Anpassung von Programm- oder Hardwarebestandteilen eines Computersystems an die gegebene Infrastruktur, sowie das System seiner Zusammenstellung. Unter einer Hardware-Konfiguration versteht man eine bestimmte Zusammenstellung der Bauteile eines Computersystems. So besteht eine Hardwarekonfiguration z.B. aus einer bestimmten Hauptplatine, einem Prozessortyp, einer bestimmten Grafikkarte und einer bestimmten Festplatte. Darüber hinaus kann das Computersystem weiterhin so konfiguriert werden, dass es beispielsweise auf einen bestimmten Drucker druckt, in dem man einen bestimmten Drucker- oder Gerätetreiber installiert.

Um eine zuverlässige Aussage über eine mögliche Laufzeitverletzung der Simulation zu erhalten, wird der Übersetzungslauf für das aus den Teilmodellen zusammengesetzte Anlagenmodell in einer Initialisierungsphase des Computersystems durchgeführt und die Teilmodelle in ihrer Ausführungsreihenfolge den Zeitdauern der jeweiligen Berechnungszeiten der Teilmodelle in einer überlagerten Darstellung abgebildet, wobei für den Fall, dass die Summe der Berechnungszeiten eine Zeitdauer einer Simulationszykluszeit überschreitet, ein Hinweis auf Echtzeitverletzung gegeben wird.

Da ein Echtzeitsimulator in Zeitscheiben Zyklusweise die Teilmodelle neu berechnet, existiert als eine Echtzeitvorgabe eine geforderte Simulationszykluszeit. Dauert die Abarbeitung des Anlagenmodells in der Simulation länger als die geforderte Simulationszykluszeit, liegt eine Echtzeitverletzung vor. Eine Herausforderung bei der Modellierung einer prozesstechnischen Anlage ist es, eine geeignete Balance zwischen Detailierungsgrad und Simulationsgeschwindigkeit der Teilmodelle zu finden. Für den Fall, dass eine Bearbeitungszeit eines Teilmodells bereits außerhalb der geforderten Simulationszykluszeit liegt, wird das Verfahren dahingehend erweitert, dass die Zeitdauer der Simulationszykluszeit als überschritten erkannt wird, und zumindest ein Teilmodell parallel auf einen zweiten Computersystem abgearbeitet wird, damit die geforderte Simulationszykluszeit wieder eingehalten werden kann.

In einer weiteren Optimierung des Verfahrens werden während einer Simulation Laufzeitmessungen an den Teilmodellen durchgeführt, wobei aus den Laufzeitmessungen konfigurationsabhängige Laufzeitvorhersagen für unterschiedliche Rechnerkonfigurationen abgeleitet werden und ein Konfigurationsdatensatz der Rechnerkonfiguration mit der ermittelten Laufzeit als Parametersatz in den Laufzeitmodellen abgespeichert wird. Hierdurch kann eine rechnerabhängige Laufzeit der Laufzeitmodelle für die Simulations-Modellierung sukzessive und adaptiv verbessert werden. Dabei werden während einer Simulation des Anlagenmodells ohne Echtzeitverletzungen kontinuierlich Laufzeitmessungen an den Teilmodellen durchgeführt und zusammen mit der gegenwärtigen Rechnerkonfiguration abgespeichert. Vorzugsweise werden "Worth Case" Laufzeiten, die primär für die Berechnung des Laufzeitmodells von Bedeutung sind, abgespeichert. Würden sich bei der Simulation die Laufzeiten so stark ändern, dass die Gefahr einer Echtzeitverletzung ansteigt, so könnte das oben genannte Verfahren zur Parallelisierung von Simulationsabläufen auf einen zweiten Computersystem erneut angewendet werden. Eine Umverteilung der Berechnungsreihenfolge würde die Gefahr der Echtzeitverletzung minimieren. Bei einer Modellierung einer neuen Anlage unter Verwendung der bereits bekannten Teilmodelle mit ihren Laufzeitmodellen kann auf die Erfahrung des Laufzeitverhaltens aus der Vergangenheit zurückgegriffen werden. Damit verbessert sich eine Anlagensimulation evolutionär mit jedem neuen Einsatz.

Die eingangs genannte Aufgabe wird ebenfalls durch eine Simulationsanordnung zur Simulation einer automatisierten Industrieanlage mit den Merkmalen des Oberbegriffes des unabhängigen Patentanspruches 6 dadurch gelöst, dass die Teilmodelle weiterhin ein Laufzeitmodell aufweisen, wobei die Laufzeitmodelle eine dem jeweiligen Teilmodell zugeordnete Berechnungszeit aufweisen, wobei das Übersetzungsmittel weiterhin dazu ausgestaltet ist, anhand der Ausführungsreihenfolge und der um die Laufzeitmodelle erweiterten Teilmodelle eine Gesamtberechnungszeit des Anlagenmodells in einer Granularität der Berechnungszeiten der Teilmodelle abzuleiten und grafisch darzustellen, wodurch eine Erkennung und Lokalisierung von echtzeitkritischen Ablauffaden in dem Anlagenmodell möglich wird.

Vorteilhafter Weise weisen die Laufzeitmodelle ein Anpassungsmittel auf, und das Anpassungsmittel ist dazu ausgestaltet, die Berechnungszeit der Teilmodelle in Abhängigkeit von zumindest einem Parameter, welcher die Berechnungszeit während der Ausführung der Teilmodelle situationsbedingt beeinflusst, dynamisch anzupassen, wobei als der zumindest eine Parameter eine Rechnerkonfiguration des Computersystems gewählt wird.

In einer weiteren optimierten Ausführung der Simulationsanordnung besitzt diese ein Überwachungsmittel, welches ausgestaltet ist, die Teilmodelle in der Ausführungsreihenfolge den Zeitdauern der jeweiligen Berechnungszeiten der Teilmodelle in einer überlagerten Darstellung abzubilden, und ist weiterhin dazu ausgestaltet, für den Fall, dass die Summe der Berechnungszeiten eine Zeitdauer einer Simulationszykluszeit überschreitet, einen Hinweis auf eine Echtzeitverletzung auszugeben.

Für ein Parallelisieren einer Simulation, d.h. die Teilmodelle auf unterschiedlichen Simulatoren (Rechnern) abzuarbeiten, ist die Simulationsanordnung ausgestaltet mit einer Schnittstelle zu einem zweiten Computersystem mit einer zweiten Simulationssoftware, weiterhin ausgestaltet, ein Teilmodell zur parallelen Abarbeitung an das zweite Computersystem zu übergeben.

Eine weiter verbesserte Simulationsanordnung ist ausgestaltet, mit einem Messmittel zur Messung der Laufzeit eines Teilmodells während einer Simulation. Weiterhin ist die Simulationsanordnung ausgestaltet, das Messergebnis für eine derzeit gültige Rechnerkonfiguration zusammen mit einem Konfigurationsdatensatz der Rechnerkonfiguration des Computersystems als Parametersatz in den Laufzeitmodellen abzuspeichern.

Zur weiteren Erläuterung des Verfahrens und der Simulationsanordnung zeigt die Zeichnung ein Ausführungsbeispiel. Es zeigt
- FIG 1: ein um ein Laufzeitmodell erweitertes Teilmodell in einem Anlagenmodell,
- FIG 2: ein Anlagenmodell und die Darstellung der Teillaufzeiten,
- FIG 3: das Anlagenmodell aus FIG 2 und eine Darstellung der Teillaufzeiten bei einer Parallelverarbeitung,
- FIG 4: das Anlagenmodell mit den Umlaufzeitmodelle erweiterten Teilmodelle und die Darstellung der Teillaufzeiten unter Einhaltung einer geforderten Simulationszykluszeit, und
- FIG 5: eine Simulationsanordnung zur Simulation einer automatisierten Industrieanlage.

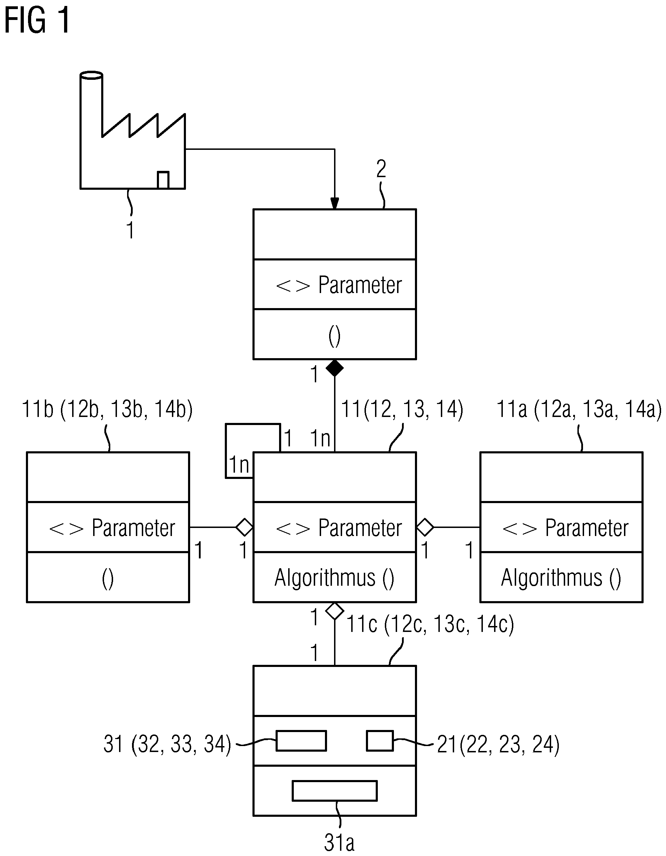

Gemäß der FIG 1 bildet ein Anlagenmodell 2 eine Industrieanlage 1 nach. Das Anlagenmodell 2 umfasst mehrere Teilmodelle 11,12,13,14, wobei bei dieser Darstellung der Modellierung und der Übersichtlichkeit halber nur das Teilmodell 11 dargestellt ist. Dem Anlagenmodell 2 ist immer zumindest ein Teilmodell 11 zugeordnet. Ein Verbindungsstrich zwischen dem Anlagenmodell 2 und dem Teilmodell 11 weist eine Initialisierung 1,...,n auf, welches bedeutet, dass das Anlagenmodell 2 n-Teilmodelle umfassen kann. In unserem Beispiel umfasst das Anlagenmodell 2 vier Teilmodelle. Jedem Teilmodell ist eine Verhaltensbeschreibung 11a,12a,13a,14a zugeordnet. Für eine spätere Visualisierung des Anlagenmodells 2 ist jedem Teilmodell 11,12,13,14 eine Visualisierungskonfiguration 11b,12b, 13b,14b zugeordnet. Zur besseren Erkennung und Lokalisierung von echtzeitkritischen Pfaden in einem Anlagenmodell, ist jedem Teilmodell 11,12,13,14 ein Laufzeitmodell 11c,12c,13c,14c zugeordnet. Demnach wird das Anlagenmodell 2 in mehrere Teilmodelle 11,12,13,14 aufgeteilt, wobei die Teilmodelle 11,12, 13,14 mit einer Verhaltensbeschreibung 11a,12a,13a,14a moduliert werden. Die Verhaltensbeschreibungen liegen vorzugsweise in Form von Berechnungsalgorithmen oder mathematischen Gleichungen vor. Die Laufzeitmodelle 11c,12c,13c,14c weisen eine dem jeweiligen Teilmodell 11,12,13,14 zugeordnete Berechnungszeit 21,22,23,24 auf. Bei einem Übersetzungslauf für eine spätere Simulation wird die Modellstruktur des Anlagenmodells 2 umfassend die Teilmodelle 11,12,13,14 in einer Initialisierungsphase eines Computersystems überprüft, dabei werden die Teilmodelle in ihrer Ausführungsreihenfolge den Zeitdauern der jeweiligen Berechnungszeiten 21,22,23,24 der Teilmodelle 11,12,1,13,14 in einer überlagerten Darstellung abgebildet.

Mit der überlagerten Darstellung ist nun eine Gesamtberechnungszeit 20 des Anlagenmodells 2 in der Granularität der Berechnungszeiten 21,22,23,24 erkennbar, wodurch eine Erkennung und Lokalisierung von echtzeitkritischen Ablaufpfaden in dem Anlagenmodell 2 möglich wird.

Die Berechnungszeit 21,22,23,24 der Teilmodelle 11,12,13,14 kann so situationsbedingt beeinflusst werden, hierzu wird in den Laufzeitmodellen 11c,12c,13c,14c ein Parametersatz 31,32,33,34 hinterlegt.

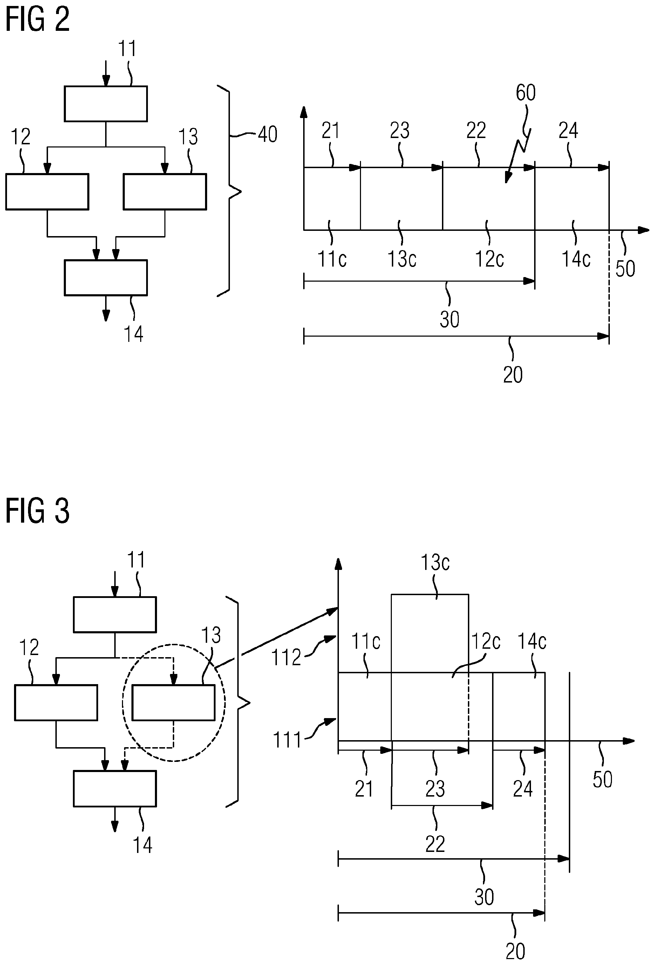

Gemäß FIG 2 ist ausgehend von dem Anlagenmodell 2 ein Übersetzungslauf und eine anschließende Darstellung der Laufzeiten der Teilmodelle 11,12,13,14 nach dem Stand der Technik dargestellt. Bei einer Initialisierung der Simulation, wie z.B. bei einem Anlagensimulator nach dem Stand der Technik "SIMIT" wird durch die Initialisierung der Simulation ein Übersetzungslauf 40 gestartet. Hierbei wird das Anlagenmodell 2 in ein ausführbares Laufzeitmodell übersetzt und Optimierungen werden vorgenommen. Durch den Übersetzungslauf 40 wird das Anlagenmodell 2 in eine Form übersetzt, welche von einem Computersystem 101, auf welchem die Simulation ausgeführt werden wird, ausgeführt werden kann, dabei wird zusätzlich eine Ausführungsreihenfolge der Teilmodelle 11,12,13,14 festgelegt.

Über einer Zeitachse 50 sind die Laufzeitmodelle 11c,12c,13c, 14c mit ihren einzelnen Berechnungszeiten 21,22,23,24 dargestellt. Auf der Zeitachse 50 nimmt das erste Laufzeitmodell 11c eine erste Berechnungszeit 21 in Anspruch, das dritte Laufzeitmodell 13c nimmt eine dritte Berechnungszeit 23 in Anspruch, das zweite Laufzeitmodell 12c nimmt eine zweite Berechnungszeit 22 in Anspruch und das vierte Laufzeitmodell 14c nimmt eine vierte Berechnungszeit 24 in Anspruch.

Aus der Summe der Berechnungszeiten 21,23,22,24 ergibt sich eine Gesamtberechnungszeit 20.

Um eine echtzeitfähige Simulation zu erhalten, müssen die Laufzeitmodelle mit ihren Berechnungszeiten aber innerhalb einer Simulationszykluszeit 30 liegen. Mit Überschreiten der Berechnungszeiten 21,23,22,24 über die Simulationszykluszeit 30 entsteht eine Laufzeitverletzung, welches durch eine Laufzeitverletzungsanzeige 60 angezeigt wird.

Gemäß FIG 3 ist eine Möglichkeit dargestellt, bei welcher eine neue Gesamtberechnungszeit 20 innerhalb der geforderten Simulationszykluszeit 30 liegt. Hingegen ist gemäß der FIG 2 in der geforderten Simulationszykluszeit beispielsweise die Berechnung des Teilmodells 12 nur teilweise erfolgt und mit dem Teilmodell 14 wurde mit der Berechnung noch gar nicht begonnen. D.h. das Anlagenmodell 2 kann z.B. nicht für einen HIL-Test mit realen Steuerungen oder für ein Operator Training System eingesetzt werden. Durch die vorliegende Erfindung wird bereits vor der Ausführung der eigentlichen Simulation eine Kenntnis darüber erlangt, ob eine Laufzeitverletzung vorliegt. Nach dem bisherigen Stand der Technik würden solche Echtzeitverletzungen oder Laufzeitverletzungen erst während einer Simulation zu Problemen führen und auch erst dann erkannt werden können. Da eine Worst Case Laufzeit eines Anlagenmodells 2 bzw. eines Simulationsmodells von den Eingabewerten abhängig ist, kann eine Echtzeitverletzung nicht nur zu Beginn der Simulation, sondern auch zu jedem anderen beliebigen Zeitpunkt auftreten. Da für ausführliche Tests oder Schulungen oftmals sehr lange Simulationen durchgeführt werden, ist es von zentraler Bedeutung, Echtzeitverletzungen schon vor der eigentlichen Simulation, z.B. wie hier beschrieben, bei der Initialisierung kurz nach dem Übersetzungslauf, zu erkennen und eventuell beheben zu können. Ist eine Echtzeitverletzung erkannt worden, können Gegenmaßnahmen ergriffen werden. Hierzu gibt es zwei Möglichkeiten:
1. Die Teilmodelle vereinfachen, d.h. durch einen höheren Abstraktionsgrad die Berechnungszeit des Teilmodells verringern,
2. Die Simulation parallelisieren, d.h. die Teilmodelle auf unterschiedlichen Simulatoren abarbeiten.

Die zweite Möglichkeit ist mit FIG 3 dargestellt. Das erste Teilmodell 11, das zweite Teilmodell 12 und das vierte Teilmodell 14 bzw. in der Abbildung ihrer Laufzeitmodelle 11c,12c,14c werden in einer ersten Ablaufebene 111 parallel zu einer zweiten Ablaufebene 112 für das dritte Teilmodell 13 bzw. das dritte Laufzeitmodell 13c abgearbeitet. Die erste Laufzeitebene 111 wird über ein erstes Computersystem 101 mit einer ersten Simulationssoftware 101a bedient, die zweite Ablaufebene 112 wird über ein zweites Computersystem 102 mit einer zweiten Simulationssoftware 102a parallel bedient.

Demnach wird auf einem anderen Rechner das dritte Teilmodell 13 parallel abgearbeitet, da dies durch die Ausführungsreihenfolge des Anlagemodells 2 zulässig ist. Die Gesamtberechnungszeit 20 liegt nun unterhalb der geforderten Simulationszykluszeit 30 und ist somit echtzeitfähig, die Simulation ist zulässig und kann begonnen werden.

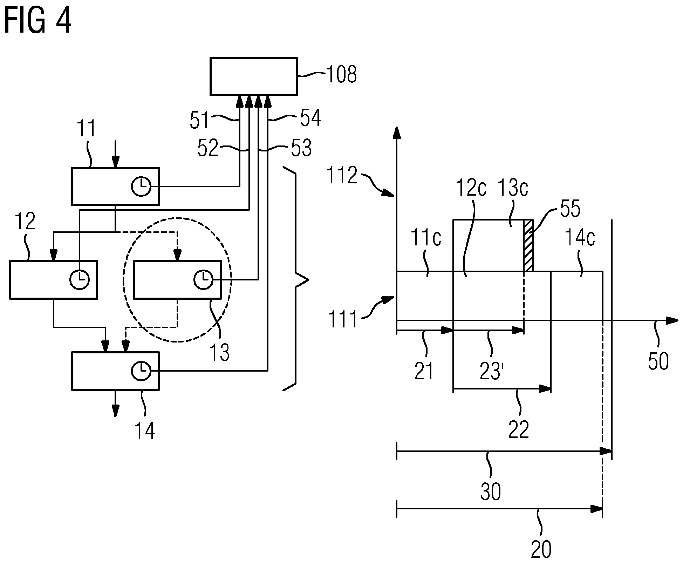

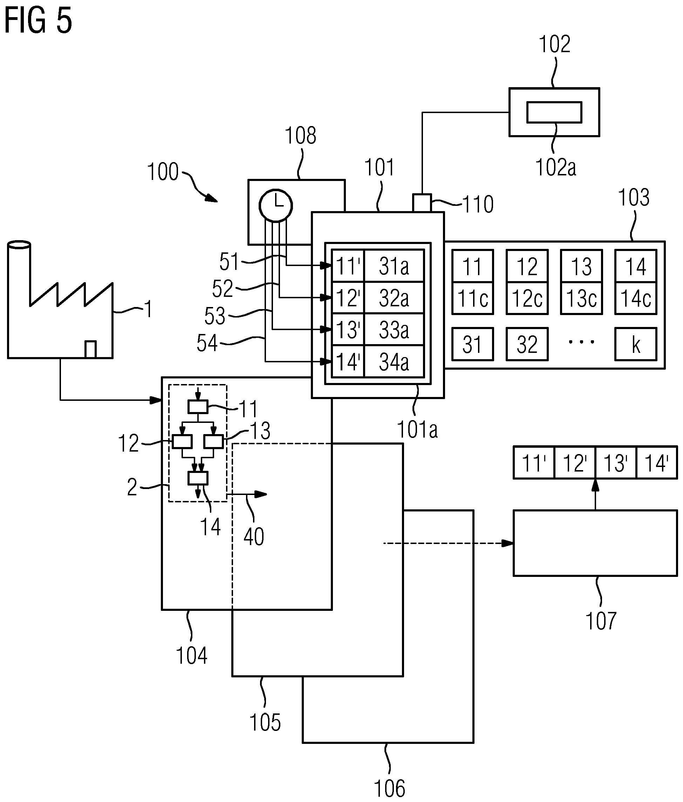

Mit der FIG 4 ist ein Simulationsablauf bzw. ein Übersetzungslauf und eine Abbildung der Laufzeitmodelle 11c,12c,13c, 14c mit ihren Berechnungszeiten in einem optimierten Simulationsmodell gemäß der Erfindung dargestellt. Das erste Laufzeitmodell 11c gemäß FIG 1 mit einem ersten Parametersatz 31 und einem ersten Anpassungsmittel 31a ausgestaltet ist, wobei das Anpassungsmittel 31a z.B. programmtechnische Laufzeitfunktionen wie "Get Runtime" oder "Measure Runtime" beinhaltet. Dadurch, dass die Laufzeitmodelle die genannten Erweiterungen aufweisen, kann über ein Messmittel 108, welches Bestandteil einer Simulationsanordnung 100 gemäß FIG 5 ist, auf die Teilmodelle 11,12,13,14 bzw. auf die Laufzeitmodelle 11c,12c,13c,14c eine Zeitmessung angewendet werden. Um dem Problem einer Echtzeitverletzung während einer Simulation vorzubeugen werden während der Simulation Laufzeitmessungen 51,52,53,54 an den Teilmodellen 11,12,13,14 durchgeführt. Aus den Laufzeitmessungen 51,52,53,54 können konfigurationsabhängige Laufzeitvorhersagen für unterschiedliche Rechnerkonfigurationen abgeleitet werden und ein Konfigurationsdatensatz der Rechnerkonfiguration mit den ermittelten Laufzeiten als Parametersatz 31,32,33,34 können in den Laufzeitmodellen 11c,12c,13c,14c abgespeichert werden.

Würden sich nun bei der Simulation die Laufzeiten bzw. die Berechnungszeiten 21,22,23,24 so stark ändern, dass die Gefahr einer Echtzeitverletzung ansteigt, so könnte das bereits in FIG 3 erwähnte Verfahren der Parallelisierung vorgenommen werden. Eine Umverteilung der Berechnungsreihenfolge würde die Gefahr der Echtzeitverletzung minimieren. Diese Verfahren der Umverteilung der Berechnungsreihenfolge während der Simulation bringen einen entscheidenden Vorteil um einer Echtzeitverletzung vorzubeugen. Bei einer Modellierung einer neuen Anlage unter Verwendung der bekannten Teilmodelle 11,12, 13,14 kann auf die Erfahrung des Laufzeitverhaltens aus der Vergangenheit zurückgegriffen werden. Damit verbessert sich die Anlagensimulation evolutionär mit jedem neuen Einsatz.

Jedes der Teilmodelle 11,12,13,14 mit seinen zugehörigen Laufzeitmodellen 11c,12c,13c,14c weist nun Mechanismen auf, wie beispielsweise Get Runtime oder Measure Runtime, welches durch ein Uhrensymbol in den Teilmodellen 11,12,13,14 angedeutet ist. In dem Laufzeitmodell 13c ist schraffiert eine Laufzeitschwankung 55 angedeutet. Diese Laufzeitschwankung 55 kann während einer Simulation durch unterschiedliche Auslastungen des Rechners auftreten. Mit der Laufzeitschwankung 55 ergibt sich für das dritte Laufzeitmodell 13c eine neue dritte Berechnungszeit 23', welche in diesem Fall glücklicherweise kleiner als die ursprüngliche Berechnungszeit 23 ist. Diese Laufzeitschwankung kann aber nur ermittelt werden, wenn während der Simulation mit dem Messmittel 108 Laufzeitmessungen an den Teilmodellen 11,12,13,14 vorgenommen werden.

Die FIG 5 zeigt eine Simulationsanordnung 100 zur Simulation einer automatisierten Industrieanlage 1. Die Simulationsanordnung 100 umfasst ein erstes Computersystem 101 mit einer ersten Simulationssoftware 101a. Für eine optionale parallele Simulation umfasst die Simulationsanordnung 100 weiterhin ein zweites Computersystem 102 mit einer zweiten Simulationssoftware 102a. Das zweite Computersystem 102 kann über eine Schnittstelle 110 des ersten Computersystems 101 mit möglichen Simulationsdaten oder Modellen versorgt werden. Weiterhin weist das erste Computersystem 101 eine Bibliothek 103 auf. In der Bibliothek 103 sind die Teilmodelle 11,12,13,14 mit ihren Laufzeitmodellen 11c,12c,13c,14c abgelegt. Zur Erstellung eines Anlagenmodells 2 steht ein Komponenteneditor 104 zur Verfügung, in dem Komponenteneditor 104 wird die Industrieanlage 1 mittels Verknüpfungen der Teilmodelle 11,12,13,14 auf das Anlagenmodell 2 abgebildet.

Das Anlagenmodell 2 wird durch eine Übersetzungslaufanwendung 40 einem Übersetzungsmittel 105 zugeführt. Das Übersetzungsmittel 105 ist ausgestaltet, das Anlagenmodell 2 durch eine Übersetzung in eine Form zu bringen, welche von dem ersten Computersystem 101, mit der ersten Simulationssoftware 101a für die Simulation, ausführbar ist.

Ein Disponentenmittel 106, welches ausgestaltet ist gemäß der Verknüpfung der Teilmodelle 11,12,13,14 eine Ausführungsreihenfolge für die Teilmodelle 11,12,13,14 festzulegen, schließt sich an das Übersetzungsmittel 105 an.

Das Übersetzungsmittel 105 und das Disponentenmittel 106 sind datentechnisch gekoppelt und mit einem Überwachungsmittel 107 verbunden. Das Überwachungsmittel 107 sorgt dafür, dass die Laufzeitmodelle 11c,12c,13c,14c in der Granularität der Berechnungszeiten der Teilmodelle 11,12,13,14 abgebildet und grafisch dargestellt werden, wobei das Überwachungsmittel 107 weiterhin dazu ausgestaltet ist, eine Echtzeitverletzung zu erkennen und zu lokalisieren.

Das Messmittel 108 zur Messung der Laufzeiten eines jeden Teilmodells 11,12,13,14 während einer Simulation ist weiterhin dazu ausgestaltet, das Messergebnis für eine derzeit gültige Rechnerkonfiguration zusammen mit einem Konfigurationsdatensatz der Rechnerkonfiguration des ersten Computersystems 101 als Parametersatz 31,32,33,34 abzuspeichern. Da jedes Teilmodell 11,12,13,14 je ein Anpassungsmittel 31a,32a,33a, 34a aufweist, können adaptiv angepasste Teilmodelle 11',12', 13',14' während der Simulation entstehen, welche für spätere Simulationen bezüglich ihres Laufzeitverhaltens in Abhängigkeit von einer Rechnerkonfiguration verbessert worden sind.

## Patentansprüche

1. Verfahren zur Simulation einer automatisierten Industrieanlage (1), wobei die Industrieanlage (1) in ein Anlagenmodell (2) abgebildet wird und das Anlagenmodell (2) in mehrere Teilmodelle (11,12,13,14) aufgeteilt wird, die Teilmodelle (11,12,13,14) werden dabei mit einer Verhaltensbeschreibung (11a,12a,13a,14a) modelliert, welche einen Berechnungsalgorithmus oder eine mathematische Gleichung aufweisen, jedes Teilmodell (11,12,13,14) wird gemäß der Abbildung der Industrieanlage (1) in das Anlagenmodell (2) mit mindestens einem anderen Teilmodell (11,12,13,14) verschaltet, wobei in Vorbereitung zu der Simulation das Anlagenmodell (2) bzw. die Teilmodelle (11,12,13,14) durch einen Übersetzungslauf in eine Form übersetzt werden, welche von einem Computersystem (101), auf welchen die Simulation ausgeführt werden wird, ausgeführt werden kann, dabei wird zusätzlich eine Ausführungsreihenfolge der Teilmodelle (11,12,13,14) festgelegt, **dadurch gekennzeichnet, dass** die Teilmodelle (11,12,13,14) vor dem Übersetzungslauf jeweils um ein Laufzeitmodell (11c,12c,13c,14c) erweitert werden, wobei die Laufzeitmodelle (11c,12c,13c,14c) eine dem jeweiligen Teilmodell (11,12,13,14) zugeordnete Berechnungszeit (21,22,23,24) aufweisen, wobei anhand der Ausführungsreihenfolge und der um die Laufzeitmodelle (11c,12c,13c,14c) erweiterten Teilmodelle (11,12,13,14) eine Gesamtberechnungszeit (20) des Anlagenmodells (2) in der Granularität der Berechnungszeiten der Teilmodelle (11,12,13,14) abgeleitet und grafisch dargestellt wird, wodurch eine Erkennung und Lokalisierung von echtzeitkritischen Ablaufpfaden in dem Anlagenmodell (2) möglich wird.

2. Verfahren nach Anspruch 1, wobei die Berechnungszeit (21, 22,23,24) der Teilmodelle in Abhängigkeit von zumindest einem Parameter (31,32,33,34), welcher die Berechnungszeit während der Ausführung der Teilmodelle (11,12,13,14) situationsbedingt beeinflusst, in den Laufzeitmodellen (11c,12c,13c,14c) hinterlegt wird, wobei als der zumindest eine Parameter eine Rechnerkonfiguration des Computersystems (101) gewählt wird.

3. Verfahren nach Anspruch 1 oder 2, wobei der Übersetzungslauf für das aus den Teilmodellen (11,12,13,14) zusammengesetzte Anlagenmodell (2) in einer Initialisierungsphase des Computersystems (101) durchgeführt wird und die Teilmodelle (11,12,13,14) in ihrer Ausführungsreihenfolge den Zeitdauern der jeweiligen Berechnungszeiten (21,22,23,24) der Teilmodelle (11,12,13,14) in einer überlagerten Darstellung abgebildet werden, wobei für den Fall, dass die Summe der Berechnungszeiten (21,22,23,24) eine Zeitdauer einer Simulationszykluszeit (30) überschreitet, ein Hinweis auf eine Echtzeitverletzung gegeben wird.

4. Verfahren nach Anspruch 3, wobei für den Fall, dass die Zeitdauer der Simulationszykluszeit (30) überschritten wird, wird zumindest ein Teilmodell (11,12,13,14) parallel auf einem zweiten Computersystem (102) abgearbeitet.

5. Verfahren nach einem der Ansprüche 2 bis 4, wobei während einer Simulation Laufzeitmessungen (51,52,53,54) an den Teilmodellen (11,12,13,14) durchgeführt werden, wobei aus den Laufzeitmessungen (51,52,53,54) konfigurationsabhängige Laufzeitvorhersagen für unterschiedliche Rechnerkonfigurationen abgeleitet werden und ein Konfigurationsdatensatz der Rechnerkonfiguration mit der ermittelten Laufzeit als Parametersatz (31,32,33,34) in den Laufzeitmodellen (11c,12c,13c,14c) abgespeichert wird.

6. Simulationsanordnung (100) zur Simulation einer automatisierten Industrieanlage (1), umfassend
- ein Computersystem (101) mit
- einer Simulationssoftware(101a),
- einer Bibliothek (103) mit einer Mehrzahl von Teilmodellen (11,12,13,14),
- einem Komponenteneditor (104) zur Erstellung eines Anlagenmodells (2) für eine Industrieanlage (1), wobei die Industrieanlage (1) mittels einer Verknüpfung der Teilmodelle (11,12,13,14) auf das Anlagenmodell (2) abbildbar ist,
wobei die Teilmodelle (11,12,13,14) einen Berechnungsalgorithmus (21,22,23,24) oder eine mathematische Gleichung aufweisen, mit
- einem Übersetzungsmittel (105), welches ausgestaltet ist, das Anlagenmodell (2) durch eine Übersetzung in eine Form zu bringen, welche von dem Computersystem (101) mit der Simulationssoftware (101a) für die Simulation ausführbar ist, mit
- einem Disponentenmittel (106), welches ausgestaltet ist gemäß der Verknüpfung der Teilmodelle (11,12,13,14) eine Ausführungsreihenfolge für die Teilmodelle (11,12,13,14) festzulegen,
**dadurch gekennzeichnet, dass** die Teilmodelle (11,12,13,14) weiterhin ein Laufzeitmodell (11c,12c,-13c,14c) aufweisen, wobei die Laufzeitmodelle (11c,12c,13c,-14c) eine dem jeweiligen Teilmodell (11,12,13,14) zugeordnete Berechnungszeit (21,22,23,24) aufweisen, wobei
das Übersetzungsmittel (105) weiterhin dazu ausgestaltet ist anhand der Ausführungsreihenfolge und der um die Laufzeitmodelle (11c,12c,13c,14) erweiterten Teilmodelle (11,12,13,14) eine Gesamtberechnungszeit (20) des Anlagenmodells(2) in der Granularität der Berechnungszeiten (21,22,23,24) der Teilmodelle (11,12,13,14) abzuleiten und grafisch darzustellen, wodurch eine Erkennung und Lokalisierung von echtzeitkritischen Ablaufpfaden in dem Anlagenmodell (2) möglich wird.

7. Simulationsanordnung (100) nach Anspruch 6, wobei die Laufzeitmodelle (11c,12c,13c,14c) ein Anpassungsmittel (31a,-32a,33a,34a) aufweisen und das Anpassungsmittel (31a,32a,-33a,34a) dazu ausgestaltet ist die Berechnungszeit (21,22,-23,24) der Teilmodelle (11,12,13,14) in Abhängigkeit von zumindest einem Parameter (31,32,33,34), welcher die Berechnungszeit (21,22,23,24) während der Ausführung der Teilmodelle (11,12,13,14) situationsbedingt beeinflusst, dynamisch anzupassen, wobei als der zumindest eine Parameter eine Rechnerkonfiguration des Computersystems (101) gewählt wird.

8. Simulationsanordnung (100) nach einem der Ansprüche 6 oder 7, mit einem Überwachungsmittel (107), welches ausgestaltet ist, die Teilmodelle (11,12,13,14) in der Ausführungsreihenfolge den Zeitdauern der jeweiligen Berechnungszeiten (21,22,23,24) der Teilmodelle (11,12,13,14) in einer überlagerten Darstellung abzubilden, und weiter dazu ausgestaltet ist, für den Fall, dass die Summe der Berechnungszeiten (21,22,23,24) eine Zeitdauer einer Simulationszykluszeit (30) überschreitet ein Hinweis auf eine Echtzeitverletzung ausgegeben wird.

9. Simulationsanordnung (100) nach einem der Ansprüche 6 bis 8, ausgestaltet mit einer Schnittstelle (110) zu einem zweiten Computersystem (102) mit einer zweiten Simulationssoftware (102a), weiterhin ausgestaltet ein Teilmodell (11,12,13, 14) zur parallelen Abarbeitung an das zweite Computersystem (102) zu übergeben.

10. Simulationsanordnung (100) nach einem der Ansprüche 6 bis 9, ausgestaltet mit einem Messmittel (108) zur Messung der Laufzeit eines Teilmodells (11,12,13,14) während einer Simulation, weiterhin ausgestaltet das Messergebnis für eine derzeit gültige Rechnerkonfiguration zusammen mit einem Konfigurationsdatensatz der Rechnerkonfiguration des Computersystems (101) als Parametersetz (31,32,33,34) in den Laufzeitmodellen (11c,12c,13c,14c) abzuspeichern.

## Claims

1. Method for simulation of an automated industrial plant (1), wherein the industrial plant (1) is simulated in a plant model (2) and the plant model (2) is divided into a number of submodels (11, 12, 13, 14), the submodels (11, 12, 13, 14) in such cases are modelled with a behaviour description (11a, 12a, 13a, 14a) which comprises a calculation algorithm or a mathematical equation, each submodel (11, 12, 13, 14) is connected in accordance with the simulation of the industrial plant (1) into the plant model (2) with at least one other submodel (11, 12, 13, 14), wherein in preparation for the simulation, the plant model (2) or the submodels (11, 12, 13, 14) is or are translated by a translation run into a form which can be executed by a computer system (101), on which the simulation will be executed, in this case an execution sequence of the submodels (11, 12, 13, 14) is additionally defined,
**characterised in that** the submodels (11, 12, 13, 14) are each expanded before the translation run by a run time model (11c, 12c, 13c, 14c), wherein the run time models (11c, 12c, 13c, 14c) have a calculation time (21, 22, 23, 24) assigned to the respective submodel (11, 12, 13, 14), wherein on the basis of the execution sequence and the submodel (11, 12, 13, 14) expanded by the run time models (11c, 12c, 13c, 14c), an overall calculation time (20) of the plant model (2) in the granularity of the calculation times of the submodels (11, 12, 13, 14) is derived and graphically presented, through which a recognition and localisation of real-time-critical execution paths in the plant model (2) is possible.

2. Method according to claim 1, wherein the calculation time (21, 22, 23, 24) of the submodel is stored in the run time models (11c, 12c, 13c, 14c) as a function of at least one parameter (31, 32, 33, 34), which influences the calculation time during the execution of the submodels (11, 12, 13, 14) according to the situation, wherein a computer configuration of the computer system (101) is selected as the at least one parameter.

3. Method according to claim 1 or 2, wherein the translation run for the plant model (2) composed of the submodels (11, 12, 13, 14) is performed in an initialisation phase of the computer system (101) and the submodels (11, 12, 13, 14) are mapped in their execution sequence to the durations of the respective calculation times (21, 22, 23, 24) of the submodels (11, 12, 13, 14) in an overlaid presentation, wherein, in the event of the sum of the calculation times (21, 22, 23, 24) exceeding a duration of the simulation cycle time (30), a warning of a real time violation is issued.

4. Method according to claim 3 wherein, in the event of the duration of the simulation cycle time (30) being exceeded, at least one submodel (11, 12, 13, 14) is executed in parallel on a second computer system (102).

5. Method according to one of claims 2 to 4, wherein run time measurements (51, 52, 53, 54) are carried out on the submodels (11, 12, 13, 14) during a simulation, wherein configuration-dependent run time predictions for different computer configurations are derived from the run time measurements (51, 52, 53, 54) and a configuration dataset of the computer configuration with the established run time is stored as a parameter set (31, 32, 33, 34) in the run time models (11c, 12c, 13c, 14c).

6. Simulation arrangement (100) for simulation of an automated industrial plant (1), comprising
- a computer system (101) with
- simulation software (101a),
- a library (103) with a plurality of submodels (11, 12, 13, 14),
- a component editor (104) for creating a plant model (2) for an industrial plant (1), wherein the industrial plant (1) is able to be simulated by means of linking the submodels (11, 12, 13, 14) to the plant model (2),
wherein the submodels (11, 12, 13, 14) have a calculation algorithm (21, 22, 23, 24) or a mathematical equation, with
- a translation means (105), which is embodied, through a translation, to bring the plant model (2) into a form which is able to be executed by the computer system (101) with the simulation software (101a) for the simulation, with
- a scheduling means (106), which is embodied, in accordance with the linkage of the submodels (11, 12, 13, 14), to define an execution sequence for the submodels (11, 12, 13, 14),
**characterised in that** the submodels (11, 12, 13, 14) also have a run time model (11c, 12c, 13c, 14c), wherein the run time models (11c, 12c, 13c, 14c) have a calculation time (21, 22, 23, 24) assigned to the respective submodel (11, 12, 13, 14), wherein
the translation means (105) is further embodied, on the basis of the execution sequence and the submodels (11, 12, 13, 14) expanded by the run time models (11c, 12c, 13c, 14), to derive and graphically present an overall calculation time (20) of the plant model (2) in the granularity of the calculation times (21, 22, 23, 24) of the submodels (11, 12, 13, 14), through which a detection and localisation of real-time-critical execution paths in the plant model (2) is possible.

7. Simulation arrangement (100) according to claim 6, wherein the run time models (11c, 12c, 13c, 14c) have an adaptation means (31a, 32a, 33a, 34a) and the adaptation means (31a, 32a, 33a, 34a) is embodied to dynamically adapt the calculation time (21, 22, 23, 24) of the submodels (11, 12, 13, 14) as a function of at least one parameter (31, 32, 33, 34), which influences the calculation time (21, 22, 23, 24) during the execution of the submodels (11, 12, 13, 14) depending on the situation, wherein a computer configuration of the computer system (101) is selected as the at least one parameter.

8. Simulation arrangement (100) according to one of claims 6 or 7, with a monitoring means (107) which is embodied to map the submodels (11, 12, 13, 14) in their execution sequence to the durations of the respective calculation times (21, 22, 23, 24) of the submodels (11, 12, 13, 14) in an overlaid presentation, and is further embodied, in the event of the sum of the calculation times (21, 22, 23, 24) exceeding a duration of a simulation cycle time (30), to issue a warning of a real time violation.

9. Simulation arrangement (100) according to one of claims 6 to 8, embodied with an interface (110) to a second computer system (102) with second simulation software (102a), further embodied to transfer a submodel (11, 12, 13, 14) to the second computer system (102) for parallel processing.

10. Simulation arrangement (100) according to one of claims 6 to 9, embodied with a measurement means (108) for measuring the run time of a submodel (11, 12, 13, 14) during a simulation, further embodied for storing the measurement results for a currently valid computer configuration together with a computer dataset of the computer configuration of the computer system (101) as a parameter set (31, 32, 33, 34) in the run time models (11c, 12c, 13c, 14c).

## Revendications

1. Procédé de simulation d'une installation (1) industrielle automatisée, dans lequel on reproduit l'installation (1) industrielle en un modèle (2) d'installation et on subdivise le modèle (2) d'installation en plusieurs sous-modèles (11, 12, 13, 14), on modélise les sous-modèles (11, 12, 13, 14) par une description (11a, 12a, 13a, 14a) de comportement, lesquels ont un algorithme de calcul ou une équation mathématique, on relie chaque sous-modèle (11, 12, 13, 14) suivant la reproduction de l'installation (1) industrielle dans le modèle (2) d'installation à au moins un autre sous-modèle (11, 12, 13, 14), dans lequel, dans la préparation de la simulation, on transpose le modèle d'installation ou les sous-modèles (11, 12, 13, 14) par une transposition en une forme, qui peut être exécutée par un système (101) d'ordinateur, sur lequel on exécute la simulation, une succession d'exécution des sous-modèles (11, 12, 13, 14) étant fixée supplémentairement,
**caractérisé en ce que** l'on étend les sous-modèles (11, 12, 13, 14) avant la transposition, chacun d'un modèle (11c, 12c, 13c, 14c) de temps de propagation, les modèles (11c, 12c, 13c, 14c) de temps propagation ayant un temps (21, 22, 23, 24) de calcul associé à chaque sous-modèle (11, 12, 13, 14), dans lequel, à l'aide de la succession d'exécution et des sous-modèles (11, 12, 13, 14) étendus des modèles (11c, 12c, 13c, 14c) de temps de propagation, on déduit un temps (20) de calcul global du modèle (2) de l'installation dans la granularité des temps de calcul des sous-modèles (11, 12, 13, 14) et on le représente graphiquement, grâce à quoi on rend possible une détection et une localisation de trajet de déroulement critique en temps réel dans le modèle (2) d'installation.

2. Procédé suivant la revendication 1, dans lequel on mémorise dans les modèles (11c, 12c, 13c, 14c) de temps de propagation le temps (21, 22, 23, 24) de calcul des sous-modèles en fonction d'au moins un paramètre (31, 32, 33, 34), qui influe, en raison de la situation, sur le temps de calcul pendant l'exécution des sous-modèles (11, 12, 13, 14), en choisissant, comme au moins un paramètre, une configuration d'ordinateur du système (101) d'ordinateur.

3. Procédé suivant la revendication 1 ou 2, dans lequel on effectue la transposition du modèle (2) d'installation composé des sous-modèles (11, 12, 13, 14) dans une phase d'initialisation du système (101) d'ordinateur et on reproduit les sous-modèles (11, 12, 13, 14) dans leur succession d'exécution en une représentation superposée aux durées des temps (21, 22, 23, 24) de calcul des sous-modèles (11, 12, 13, 14), dans lequel, dans le cas où la somme des temps (21, 22, 23, 24) de calcul dépasse une durée d'un temps (30) de cycle du cycle de simulation, on donne une indication d'une infraction en temps réel.

4. Procédé suivant la revendication 3, dans lequel, dans le cas où la durée dépasse le temps (30) de cycle du cycle de simulation, on élabore au moins un sous-modèle (11, 12, 13, 14) en parallèle sur un deuxième système (102) d'ordinateur.

5. Procédé suivant l'une des revendications 2 à 4, dans lequel, pendant une simulation, on effectue des mesures (51, 52, 53, 54) du temps de propagation sur les sous-modèles (11, 12, 13, 14), dans lequel, à partir des mesures (51, 52, 53, 54) de temps de propagation, on déduit des prédictions de temps de propagation, qui dépendent de la configuration pour des configurations d'ordinateur différentes et on mémorise, dans les modèles (11c, 12c, 13c, 14c) de temps de propagation, un jeu de données de configuration de la configuration d'ordinateur avec le temps de propagation déterminé comme jeu (31, 32, 33, 34) de paramètre.

6. Système (100) de simulation pour simuler une installation (1) industrielle automatisée, comprenant
- un système (101) d'ordinateur ayant
- un logiciel (101a ) de simulation,
- une bibliothèque (103) ayant une pluralité de sous-modèles (11, 12, 13, 14),
- un éditeur (104) de composants pour établir un modèle (2) d'une installation (1) industrielle, l'installation (1) industrielle pouvant être reproduite sur le modèle (2) d'installation au moyen d'une combinaison des sous-modèles (11, 12, 13, 14), les sous-modèles (11, 12, 13, 14) ayant un algorithme (21, 22, 23, 24) de calcul ou une équation mathématique, comprenant
- un moyen (105) de transposition, conformé pour mettre le modèle (2) d'installation par une transposition sous une forme, qui peut être exécutée pour la simulation par le système (101) d'ordinateur, ayant le logiciel (101a ) de simulation, comprenant
- un moyen (106) de gestion, conformé pour, selon la combinaison des sous-modèles (11, 12, 13, 14), fixer une succession d'exécution des sous-modèles (11, 12, 13, 14),
**caractérisé en ce que** les sous-modèles (11, 12, 13, 14) ont, en outre, un modèle (11c, 12c, 13c, 14c) de temps de propagation, les modèles (11c, 12c, 13c, 14c) de temps de propagation ayant un temps (21, 22, 23, 24) de calcul affecté à chaque sous-modèle (11, 12, 13, 14), dans lequel le moyen (105) de transposition est conformé, en outre, pour, à l'aide de la succession d'exécution et des sous-modèles (11, 12, 13, 14) étendus des modèles (11c, 12c, 13c, 14c) de temps de propagation, déduire un temps (20) de calcul global du modèle (2) d'installation dans la granularité des temps (21, 22, 23, 24) de calcul des sous-modèles (11, 12, 13, 14) et le représenter graphiquement, grâce à quoi une détection ou une localisation de trajet de déroulement critique en temps réel est possible dans le modèle (2) d'installation.

7. Système (100) de simulation suivant la revendication 6, dans lequel les modèles (11c, 12c, 13c, 14c) de temps de propagation ont un moyen (31a, 32a, 33a, 34a) d'adaptation et le moyen (31a, 32a, 33a, 34a) d'adaptation est conformé pour adapter dynamiquement le temps (21, 22, 23, 24) de calcul des sous-modèles (11, 12, 13, 14) en fonction d'au moins un paramètre (31, 32, 33, 34), qui influe en raison de la situation pendant l'exécution des sous-modèles (11, 12, 13, 14) sur le temps (21, 22, 23, 24) de calcul, dans lequel une configuration d'ordinateur du système (5) d'ordinateur est choisie comme au moins un paramètre.

8. Système (100) de simulation suivant l'une des revendications 6 ou 7, comprenant un moyen (107) de contrôle, conformé pour reproduire les sous-modèles (11, 12, 13, 14) dans la succession d'exécution en une représentation superposée aux durées des temps (21, 22, 23, 24) de calcul respectifs des sous-modèles (11, 12, 13, 14) et conformé, en outre, pour, dans le cas où la somme des temps (21, 22, 23, 24) de calcul dépasse une durée d'un temps (30) de cycle de simulation, donner une indication sur une infraction en temps réel.

9. Système (100) de simulation suivant l'une des revendications 6 à 8, conformé en ayant une interface (110) avec un deuxième système (102) d'ordinateur ayant un deuxième logiciel (102a) de simulation, conformé, en outre, pour transmettre un sous-modèle (11, 12, 13, 14) pour le déroulement en parallèle sur le deuxième système (102) d'ordinateur.

10. Système (100) de simulation suivant l'une des revendications 6 à 9, conformé en ayant un moyen (108) de mesure du temps de propagation d'un sous-modèle (11, 12, 13, 14) pendant une simulation, conformé, en outre, pour mémoriser comme jeu (31, 32, 33, 34) de paramètres dans les modèles (11c, 12c, 13c, 14c) de temps de propagation, le résultat de la mesure d'une configuration d'ordinateur valable à cet instant ensemble avec un jeu de données de configuration de la configuration d'ordinateur du système (101) d'ordinateur.
